# EUROPEAN PATENT SPECIFICATION

(11) **EP 3 777 490 B1**
(45) Date of publication and mention of the grant of the patent: **07.06.2023**
(21) Application number: 19709846.0
(22) Date of filing: 25.02.2019
(51) Int. Cl.: H05K 5/00, F24C 7/08, H05K 7/14

(54) **A HOUSEHOLD APPLIANCE COMPRISING CARD HOLDER**
HAUSHALTSGERÄT MIT KARTENHALTER
APPAREIL ÉLECTROMÉNAGER COMPRENANT UN PORTE-CARTE

(30) Priority: 30.03.2018 TR 201804511
(43) Date of publication of application: 17.02.2021
(73) Proprietor: Arçelik Anonim Sirketi, 34445 Istanbul (TR)
(72) Inventor: ODABAS, Burcin, 34445 ISTANBUL (TR); YIRMILI, Yasin Sedat, 34445 ISTANBUL (TR); KARAGOZ, Recep, 34445 ISTANBUL (TR); SARIER, Hakan, 34445 ISTANBUL (TR); CENGIZ, Osman, 34445 ISTANBUL (TR)
(86) International application number: PCT/EP2019/054569
(87) International publication number: WO 2019/185254

(56) References cited:
- EP-A1- 2 024 685
- EP-A1- 2 390 577
- DE-A1-102008 043 457

## Description

The present invention relates to a household appliance with enhanced electronic card placement and electronic control efficiency.

The electronic cards provided in household appliances, comprise electronic software products enabling controlling the functions of the appliances. These are disposed on the rear side of a control panel of household appliances, which are usually positioned on the front or upper surfaces, at sections easily accessible for users. The electronic cards are thus protected from temperature variations likely to arise during operation of the appliance, or from contacting substances likely to cause malfunctions on contact, such as water. Since control panels enable users to physically enter commands by means of a keyboard and/or capacitive screen, they are placed on the outer surface of the appliance, in an arrangement enabling user access. Problems may be encountered in assembling control panels and electronic cards giving function to a panel, on glass or mirror-like surfaces which are currently preferred for having a more aesthetic appearance.

Assembly with mechanical components such as screws on glass surfaces damage the surface and adversely affect surface strength. Otherwise, when assembly is made by means of an adhesive such as silicone, the distance between the surface and the control panel, and therefore the electronic card may not be uniform due to the adhesive having a tendency to deform during application, with making it difficult for a user to input commands effectively.

State of the art United States patent document no. US8553419 describes a card holder structure enabling insertion and ejection of an electronic card. DE102008043457 discloses a circuit board support arrangement for use in household appliance.State of the art European patent no EP2390577 is directed to a user interface for an appliance of household or industrial type, especially for a domestic appliance. The user interface comprises a touch-field unit and an electronic board both being detachably mounted to a mounting frame.

State of the art European patent no EP2024685 discloses a domestic oven, which has at least one operator control and/or display printed circuit board which is arranged in ar accommodation region.

The aim of the present invention is to realize a household appliance controlled by an electronic card and with enhanced usage efficiency, by providing secure placement of the electronic card by means of a card holder.

The household appliance realized to achieve the aim of the present invention and disclosed in the first claim and the dependent claims, comprises a body, a panel provided on an outer surface of the body suitable for being accessed, and a card holder adapted to be placed on the surface of the panel facing into the body, suitable for housing an electronic card therein. The card holder enables the electronic card to be securely fixed.

In the household appliance of the invention, a frame is provided in which an electronic card is placed. The frame can be placed on the inner surface of the front panel of the household appliance. Placement can be performed by attaching the frame to the panel by means of silicone or a similar adhesive. The frame is sized suitably to placed an electronic card therein, and is generally rectangular. When placed in the frame, the electronic card is supported by at least one holder arm on the rear surface of the electronic card which is opposite of the surface facing the panel. The holder arm is used to fix the position of the electronic card in the frame and to move it closer to the panel surface. The holder arm and the frame are preferably made of a flexible material. Since this enables the holder arm an the frame to take a shape so as to support the electronic card from behind and to position it at a threshold distance from the panel, the electronic card's efficiency in detecting is enhanced, when a user activates the controls via the panel.

In an embodiment of the invention, the card holder comprises at least one extension provided on the surface of the holder arm contacting the electronic card, enabling fixing the electronic card by supporting it in panel surface direction. The extension may be shaped as one or multiple recesses and projections. The projecting structure moves the card closer to the panel by applying pressure on the surface of the electronic card. The holder arm presses the electronic card against the front surface of the appliance without damaging it due to its flexible structure. Since the electronic card is fixed by being placed between the frame and the holder arm, no perforation is performed by mechanical members such as a screw, thereby preventing the card and the panel surface from being damaged.

The card holder comprises a holder arm shaped as an arc curved towards the electronic card surface. The arc form is shaped curved on the surface of the holder arm pressing on the electronic card from the portions connected to the frame. The card holder thus presses the electronic card against the panel surface, thereby enabling efficient transmission from the front surface of the panel to the card.

The holder arm is moveable between a closed state and an open state in order to facilitate access into the frame. The holder arm enables placing the electronic card into the frame. The holder arm can be movably mounted so as to be attached on any point on the frame's edge or to be pivoted about a point. The holder arm can also be completely detachably mounted on the frame by being attached thereon. The electronic card can be accessed with ease.

In an embodiment of the invention, the card holder comprises a locking apparatus enabling the movable holder arm to be fixed on the frame. The movable holder arm is placed on the frame at one of its ends, preferably pivotally about a shaft. In this embodiment, the locking apparatus comprises a tab provided on the movable end of the holder arm, and a slot provided on the frame, in which the tab settles when the movable end contacts the frame. The movable end of the holder arm is fixed on the frame when the tab settles in the slot. The holder arm is thus fixed on the frame, preventing the electronic card from escaping the frame. When the tab is removed out of the slot, the movable end of the holder arm is moved away from the frame, terminating its contact with the electronic card, thereby enabling the electronic card to be removed from the card holder.

In another embodiment of the invention, the household appliance comprises a panel made of a material suitable for light transmittance. Material suitable for light transmittance may usually consist of glass or reflective glass derivatives such as mirror. Due to being translucent, this material prevents false reflections and deflections likely to inhibit electronic communication or harm data transmission. As glass is a fragile material due to its nature, it is difficult to mount a component thereon. It is possible to attach the frame on the panel surface by adhering. A problem in command transmission to the electronic card likely to arise due to adhering, is avoided by moving the electronic card closer to the panel by the holder arm pressing the card in panel direction. A user command is thus efFectively transmitted to the electronic card without experiencing any transmission problems.

In an embodiment of the invention, the household appliance is a cooking appliance. The cooking appliance may be an oven or a hob. A control unit is provided, enabling selection of cooking functions presented on the front panel surface of the oven or the hob. The control unit enables activating the selections by pressing on the electronic card provided on the rear portion of the panel. The cooking appliance is thus easily controlled.

By means of the invention, a household appliance is realized, in which an electronic card is assembled with enhanced control efficiency.

The household appliance realized to achieve the aims of the present invention is illustrated in the accompanying drawings, wherein:
Figure 1 is a perspective view of the household appliance.
Figure 2 is a perspective view of the panel and the card holder from below, in an embodiment of the invention.
Figure 3 is a perspective view of the card holder in an embodiment of the invention.
Figure 4 is a perspective view of the card holder in an embodiment of the invention.

The elements in the figures are numbered individually and the correspondence of these numbers are given hereinafter.
1. Household appliance
2. Body
3. Panel
4. Card holder
5. Frame
6. Holder arm
7. Extension
8. Locking apparatus

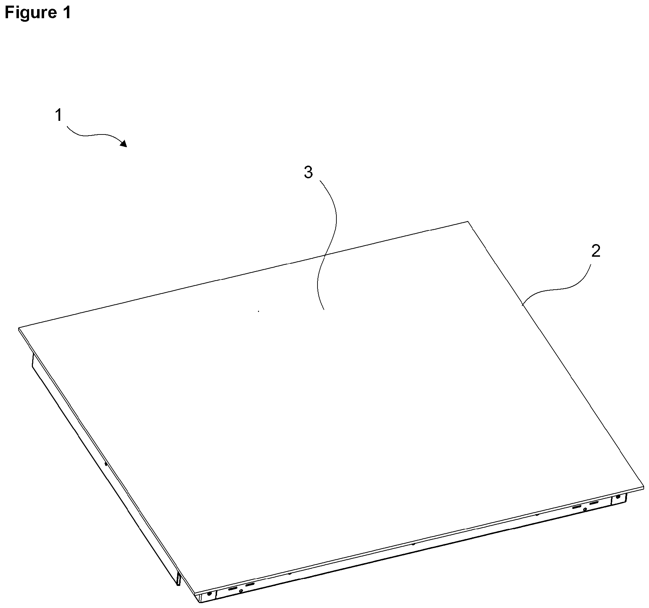

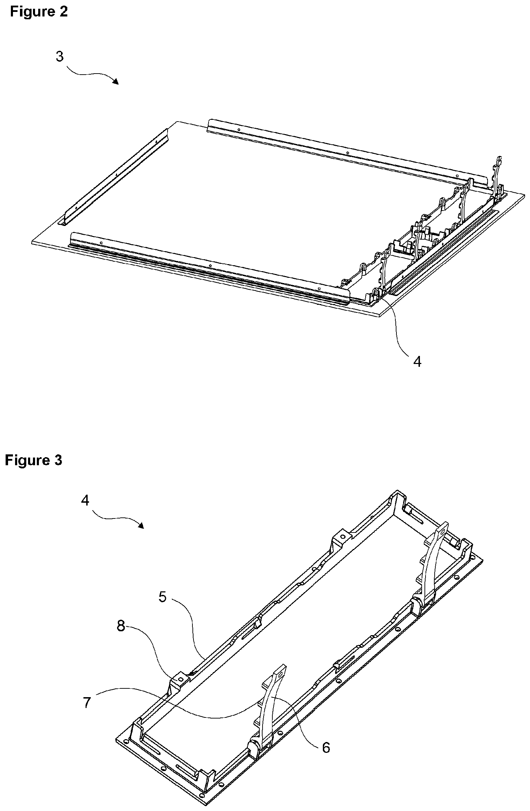

The household appliance (1) comprises a body (2), a panel (3) provided on an outer surface of the body (2) suitable for being accessed, and a card holder (4) adapted to be placed on the surface of the panel (3) facing into the body (2), suitable for housing an electronic card therein (Figure 1 and Figure 2).

The household appliance (1) of the invention comprises a frame (5) in which the electronic card is placed, at least one holder arm (6) adapted to support the electronic card by extending from an edge of the frame (5) to the other, pressing on the electronic card so as to move the electronic card closer to the panel (3) surface, and a card holder (4) enabling housing the electronic card. The frame (5) composing a volume in which the electronic card is placed, restricts the motion of the electronic card in vertical and horizontal direction by enclosing the electronic card when it is placed into said volume. When the electronic card is placed into the frame (5), the holder arm (6) applies pressure on the electronic card in panel (3) direction. The electronic card is prevented from escaping the frame (5) by means of the contact between the holder arm (6) and the electronic card.

The card holder (4) of the invention comprises at least one extension (7) provided on the surface of the holder arm (6) contacting the electronic card, enabling fixing the electronic card by supporting it in panel (3) surface direction. The extension (7) forming a projection on the holder arm (6) contacting the electronic card, such that the holder arm (6) applies pressure on the electronic card so as to prevent its movement.

The card holder (4) comprises a holder arm (6) shaped as an arc curved towards the electronic card surface. The electronic card is pressed against the panel (3) thanks to the curved shape of the holder arm (6) extending towards the electronic card. The electronic card is thus prevented from moving in the frame (5) after being placed therein. By this, a distance variation between the electronic card and the panel (3) during usage of the household appliance (1) is averted, enabling effective operation of the electronic card.

The card holder (4) comprises a movable holder arm (6) fulfilling the function of opening and closing in order to facilitate access into the frame. A first end of the holder arm (6) is connected to the frame (5) so as to be pivotable about the end to which it is connected. The free end of the holder arm (6) moves so as to contact and move away from the frame (5). The electronic card is thus enabled to be easily placed into and removed out of the card holder (4) (Figure 2 and Figure 3).

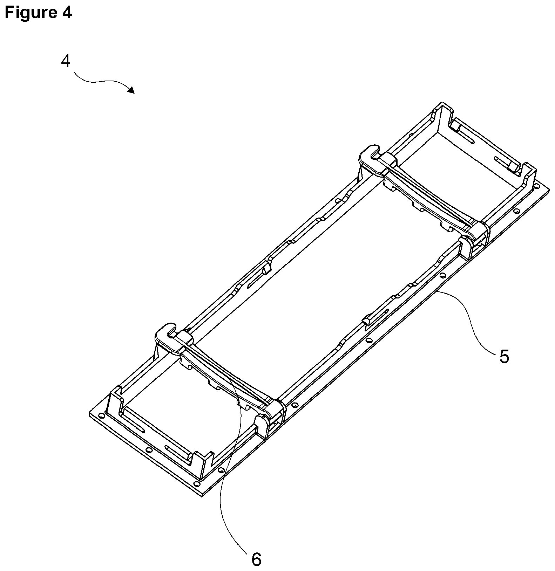

In an embodiment of the invention, the card holder (4) comprises a locking apparatus (8) enabling the movable holder arm (6) to be fixed on the frame (5). The holder arm (6) enables the electronic card to be housed in the frame (5) so as to support the card after its placement into the frame (5), extends from an edge of the frame (5) to the other, and is closed on the card. A locking apparatus (8) is provided in order to be able to fix the holder arm (6) in this closed position in which the free end of the holder arm (6) supports the electronic card from its rear surface and both ends are connected to the frame (5). The locking apparatus (8) is integrated to the frame (5) surface and is adapted for the holder arm (6) to be attached thereon. By this, the locking apparatus (8) enables the electronic card to be securely housed by fixing the holder arm (6) on the frame (5) (Figure 4).

In an embodiment of the invention, the household appliance (1) comprises a panel (3) made of a material suitable for light transmittance. In this embodiment, the material also enables electrical data transmission. The process control of the household appliance (1) is enabled by the electronic card positioned behind the panel (3). The panel (3) thus enhances aesthetic appearance as well as transmission efficiency of user commands.

In an embodiment of the invention, the household appliance (1) is a cooking appliance. Cooking appliances are subjected to high temperatures as their functions are generally based on heating. Replacement is facilitated of the electronic card executing the control functions of the household appliance (1) in case it becomes damaged in long term due to certain factors such as heat.

In the household appliance (1) of the invention, communication between the electronic card and the household appliance (1) is efFiciently performed by means of a card holder (4) enabling the electronic card to be held stationary, in a proper position by means of the frame (5) and a holder arm (6).

## Claims

1. A household appliance (1) **comprising** a body (2), a panel (3) provided on an outer surface of the body (2) suitable for being accessed, and a card holder (4) adapted to be placed on the surface of the panel (3) facing into the body (2), suitable for housing an electronic card therein, a frame (5) in which the electronic card is placed, at least one holder arm (6) adapted to support the electronic card by extending from an edge of the frame (5) to the other **characterized in that** the holder arm (6) is shaped as an arc curved towards the surface of the electronic card and adapted to press on the electronic card so as to move the electronic card closer to the panel (3) surface, wherein a first end of the holder arm (6) is pivotably attached to the frame (5) such that the holder arm (6) is moveable between a closed state and an open state in order to facilitate access into the frame (5).

2. A household appliance (1) according to claim 1, **characterized by** at least one extension (7) provided on the surface of the holder arm (6) contacting the electronic card, enabling fixing the electronic card by supporting it in panel (3) surface direction.

3. A household appliance (1) according to claim 1 or 2, **characterized by** the frame (5) comprising a locking apparatus (8) enabling fixing the movable holder arm (6), from a second end of the holder arm (6) opposite to the first end thereof, on the frame (5).

4. A household appliance (1) according to any one of the preceding claims, **characterized by** the panel (3) being made of a material suitable for light transmittance.

5. A household appliance (1) according to any one of the preceding claims which is a cooking appliance.

## Patentansprüche

1. Ein Haushaltsgerät (1) **umfasst** einen Körper (2), eine Platte (3), die auf einer äußeren Oberfläche des Körpers (2) vorgesehen ist, die für einen Zugriff geeignet ist, und einen Kartenhalter (4), der angepasst ist, um auf der Oberfläche der Platte (3) platziert zu werden, die in den Körper (2) zeigt, geeignet zum Aufnehmen einer elektronischen Karte darin, einen Rahmen (5), in dem die elektronische Karte platziert ist, mindestens einen Haltearm (6), der angepasst ist, um die elektronische Karte zu halten, indem er sich von einer Kante des Rahmens (5) zur anderen erstreckt, **gekennzeichnet ist es dadurch,** dass der Haltearm (6) als ein Bogen geformt ist, der in Richtung der Oberfläche der elektronischen Karte gekrümmt ist und angepasst ist, auf die elektronische Karte zu drücken, um die elektronische Karte näher an die Oberfläche der Platte (3) zu bewegen, wobei ein erstes Ende des Haltearms (6) schwenkbar an dem Rahmen (5) befestigt ist, so dass der Haltearm (6) zwischen einem geschlossenen Zustand und einem offenen Zustand bewegbar ist, um den Zugang in den Rahmen (5) zu erleichtern.

2. Ein Haushaltsgerät (1), wie in Anspruch 1 aufgeführt, **ist dadurch gekennzeichnet, dass** mindestens eine Verlängerung (7) auf der Oberfläche des Haltearms (6) vorgesehen ist, die die elektronische Karte berührt, wodurch die Befestigung der elektronischen Karte ermöglicht wird, indem sie in Richtung der Oberfläche der Platte (3) gehalten wird.

3. Ein Haushaltsgerät (1), wie in Anspruch 1 oder 2 aufgeführt, **ist dadurch gekennzeichnet, dass** der Rahmen (5) eine Verriegelungsvorrichtung (8) umfasst, die eine Befestigung des beweglichen Haltearms (6) von einem zweiten Ende des Haltearms (6) gegenüber dem ersten Ende davon an dem Rahmen (5) ermöglicht.

4. Ein Haushaltsgerät (1), wie in einem der vorherigen Ansprüchen aufgeführt, **ist dadurch gekennzeichnet, dass** die Platte (3) aus einem lichtdurchlässigen Material hergestellt ist.

5. Ein Haushaltsgerät (1), wie in einem der vorherigen Ansprüchen aufgeführt, ist ein Kochgerät.

## Revendications

1. Un appareil ménager (1) **comprenant** un corps (2), un panneau (3) situé sur une surface extérieure du corps (2) et accessible, et un porte-carte (4) destiné à être placé sur la surface du panneau (3) orienté vers l'intérieur du corps (2) et destiné à accueillir une carte électronique, un cadre (5) dans lequel la carte électronique est placée, au moins un bras de support (6) adapté pour soutenir la carte électronique en s'étendant d'un bord à l'autre du cadre (5) **caractérisé en ce que** le bras de support (6) a la forme d'un arc incurvé vers la surface de la carte électronique et adapté pour appuyer sur la carte électronique de manière à rapprocher la carte électronique de la surface du panneau (3), dans lequel une première extrémité du bras de support (6) est fixée de manière pivotante au cadre (5) de sorte que le bras de support (6) peut être déplacé entre un état fermé et un état ouvert afin de faciliter l'accès au cadre (5).

2. Un appareil ménager (1) selon la déclaration 1, **caractérisé par** au moins une extension (7) prévue sur la surface du bras de support (6) en contact avec la carte électronique, permettant de fixer la carte électronique en la soutenant dans la direction de la surface du panneau (3).

3. Un appareil ménager (1) selon la déclaration 1 ou 2, **caractérisé par le fait que** le cadre (5) comprend un dispositif de verrouillage (8) permettant de fixer le bras porteur mobile (6), à partir d'une deuxième extrémité du bras porteur (6) opposée à la première extrémité de celui-ci, sur le cadre (5).

4. Un appareil ménager (1) selon l'une quelconque des déclarations précédentes, **caractérisé par le fait que** le panneau (3) est constitué d'un matériau adapté à la transmission de la lumière.

5. Un appareil ménager (1) selon l'une quelconque des déclarations précédentes qui est un appareil de cuisson.
